Europäisches Patentamt

European Patent Office

Office européen des brevets

(19)

(11) Numéro de publication: **0 239 426 B1**

(12) **FASCICULE DE BREVET EUROPEEN**

(45) Date de publication du fascicule du brevet:
23.05.90

(51) Int. Cl.⁵: **G01R 33/34**

(21) Numéro de dépôt: **87400245.4**

(22) Date de dépôt: **03.02.87**

(54) Antenne de réception pour appareil d'imagerie par résonance magnétique nucléaire.

(30) Priorité: **07.02.86 FR 8601722**

(43) Date de publication de la demande:
**30.09.87 Bulletin 87/40**

(45) Mention de la délivrance du brevet:
**23.05.90 Bulletin 90/21**

(84) Etats contractants désignés:
**DE GB IT NL**

(56) Documents cités:
**EP-A- 0 141 383**
**WO-A-84/00214**
**FR-A- 885 620**
**GB-A- 2 161 940**
**US-A- 2 517 968**

**FUNKSCHAU,**
**no. 4, 11 février 1980, pages 95-96, Munich, DE; H.**
**FEICHTINGER: "Aktive Empfangsantenne"**

(73) Titulaire: **GENERAL ELECTRIC CGR S.A., 100, rue Camille-Desmoulins, F-92130 Issy les Moulineaux(FR)**

(72) Inventeur: **Jacob, Hervé, THOMSON-CSF SCPI 19, avenue de Messine, F-75008 Paris(FR)**
Inventeur: **Bossaert, Jean, THOMSON-CSF SCPI 19, avenue de Messine, F-75008 Paris(FR)**

(74) Mandataire: **Ballot, Paul Denis Jacques et al, Cabinet Ballot-Schmit 7, rue le Sueur, F-75116 Paris(FR)**

ACTORUM AG

## Description

La présente invention a pour objet une antenne de récéption pour appareil d'imagerie par résonance magnétique nucléaire (RMN). Elle trouve plus particulièrement son application dans le domaine médical où l'imagerie par RMN s'avère précieuse comme aide au diagnostic. Elle peut trouver néanmoins son application dans d'autres domaines. L'état de la technique est illustré par les documents: FR-A 885 620 et WO-A 8 400 214.

Un appareil d'imagerie par RMN comporte essentiellement des moyens pour soumettre un corps à examiner à un champ magnétique constant et intense $B_0$. Puis, soumis à cette influence,le corps reçoit d'une antenne d'émission une excitation radiofréquence pour provoquer une résonance de l'oscillation des moments magnétiques de ses particules. Dès que cette excitation radiofréquence cesse, on mesure le signal de résonance émis en retour par le corps quand les moments magnétiques des particules tendent à se réaligner avec le champ $B_0$. Pour recevoir le signal émis on utilise quelquefois des antennes dites de surface. Les antennes dites de surface sont des antennes posées à la surface du corps. Leur intérêt par rapport aux antennes solidaires de l'appareil est essentiellement qu'elles peuvent être placées à proximité immédiate des particules éméttrices. Les antennes d'émission classiquement agrippées à l'appareil en sont, elles, nettement plus éloignées. De l'usage de ces antennes de surface résulte une amélioration sensible du rapport signal sur bruit du signal détécté. Une antenne de surface se compose principalement d'un conducteur formant une boucle de courant. L'impédance selfique de ce circuit d'antenne est accordée à la fréquence de résonance au moyen d'une capacité. La sensibilité de l'antenne dépend directement du coefficient de surtension du circuit résonnant ainsi réalisé. Dans la conception des circuits d'antenne on vise à minimiser les pertes en agissant d'une part sur les formes et dimensions du circuit et en agissant d'autre part sur le choix des composants, de haute qualité, qui les composent.

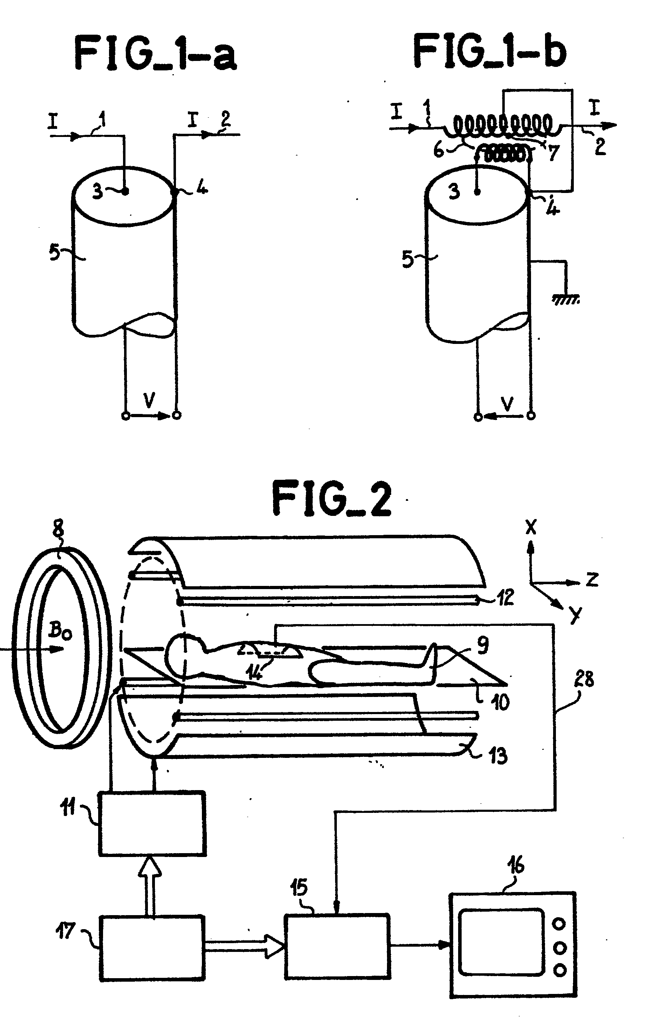

Mais d'autres conditions doivent aussi être remplies en particulier pour minimiser les bruits. Par exemple il est connu de répartir les capacités d'accord le long du circuit : en agissant ainsi on réduit la détection de champs électriques. Les impédances des selfs et capacités constituant l'antenne en sont alors diminuées, ce qui a pour effet de réduire les tensions à leurs extrémités et le champ électrique qui en résulte. Autrement dit, on ne capte pas le signal de perte diéléctrique qui apparaît dans le corps. Par ailleurs pour assurer la meilleure réception du signal de résonance, ce signal est conduit par une ligne adaptée jusqu'à un circuit de traitement du signal. La ligne adaptée est en général une ligne coaxiale d'impédance caractéristique 50 Ohms. Un autre facteur intervient directement dans la qualité du signal reçu : il concerne la symétrisation de l'antenne. Les figures 1a et 1b montrent respectivement des antennes non symétriques et symétriques. Dans la figure 1a deux éléments rayonnants 1 et 2 sont raccordés à l'âme 3 et à la tresse 4 d'un câble coaxial 5. Celui-ci est alimenté par une source de signal V. Lors de l'émission, ou de la réception, il y a un déséquilibre entre les parties rayonnantes : une première partie est limitée à l'élément d'antenne 1, alors que l'autre partie comporte l'élément d'antenne 2 et la tresse 4 du câble 5. Sur la figure 1b est représenté un dispositif connu de symétrisation. L'alimentation du doublet 1-2 est effectuée au moyen d'un couplage magnétique 6 dont le point milieu 7 du secondaire est relié à la tresse du câble 5. En symétrisant ainsi l'alimentation, on évite tout courant de gaine dans le câble coaxial. De cette façon l'antenne devient insensible aux perturbations radioéléctriques extérieures. Malheureusement cette symétrisation par transformateur n'est pas applicable à l'imagerie par RMN pour laquelle la présence du couplage magnétique 6 est rédhibitoire. Il en résulte qu'en RMN la symétrisation est négligée.

La présente invention a pour objet de remédier à cet inconvénient en proposant des antennes symétrisées. Pour cette symétrisation une solution originale, sans couplage magnétique additionnel, est proposée qui réalise en même temps l'adaptation d'impédance d'antenne. En effet le couplage 6, dont on doit maintenant se passer, a une autre caractéristique : celle d'adapter l'impédance de l'antenne 1-2 à l'impédance caractéristique du câble coaxial 5.

L'invention a pour objet une antenne de surface de réception pour appareil d'imagerie par résonance magnétique nucléaire comportant des moyens pour assurer sa symétrisation pour la réception du signal de résonance et un circuit pour assurer la transformation de son impédance pour la transmission de ce signal de résonance caractérisée en ce que les moyens de symétrisation comportent une boucle selfique accordée en fréquence par une capacité répartie comportant au moins deux capacités disposées symétriquement dans la boucle, et un circuit de réception du signal induit dans la boucle, branché aux bornes de l'une des capacités, ce circuit de réception comportant un tronçon d'une ligne haute fréquence dont un conducteur de masse participe à la boucle selfique et dont une âme, qui sert à conduire le signal reçu, est reliée d'une part au reste de la boucle et d'autre part au circuit de tranformation d'impédance.

L'invention sera mieux comprise à la lecture de la description qui suit et à l'examen des figures qui l'accompagnent. Celles ci ne sont données qu'à titre indicatif et nullement limitatif de l'invention. Sur les figures les mêmes repères désignent les mêmes éléments. Elles montrent :

- Figure 1a et 1b des éléments d'antenne de l'état de la technique déjà décrit ci-dessus ;
- Figure 2 : un appareil d'imagerie par RMN comportant une antenne selon l'invention ;
-Figure 3a et 3b un schéma de principe et un exemple particulier de réalisation d'une antenne selon l'invention.

La figure 2 montre un appareil d'imagerie par résonance magnétique nucléaire. Cet appareil comporte essentiellement des premiers moyens 8 pour soumettre un corps 9 supporté par un plateau 10 à un champ magnétique intense $B_0$. Dans cette situation le corps 9 reçoit en outre une excitation radiofréquence produite par des moyens générateur 11 et transmise, par exemple, par une antenne à quatre conducteurs tels que le conducteur 12. Comme la réponse radiofréquence du signal est une réponse en volume l'appareil comporte de plus des bobines 13, dites de gradient, reliées également aux moyens générateur 11 pour particulariser des régions de l'espace où des coupes sont à imager. Pour la réception, à l'aplomb de ces coupes, est placée sur le corps 9 une antenne de surface 14 munie du perfectionnement de l'invention. Cette antenne de surface est symétrisée et adaptée. Elle est reliée par une ligne 28 à des circuits de traitement 15 reliés à des moyens 16 de visualisation ou de mémorisation pour visualiser ou mémoriser les images des coupes. Les moyens générateur 11 et les circuits de traitement 15 sont pilotés par un séquenceur 17.

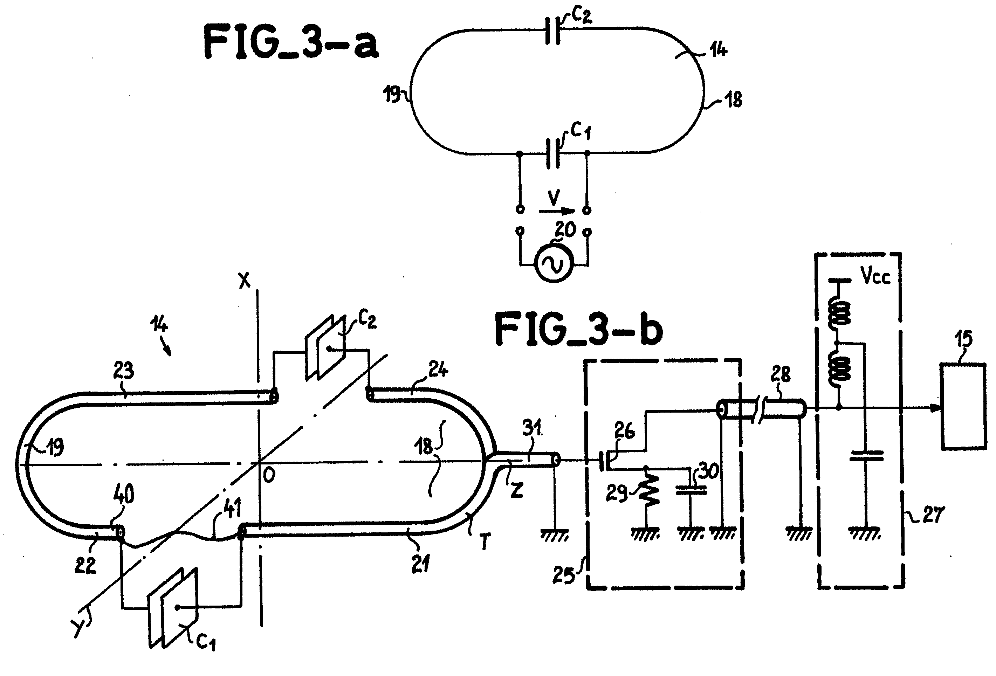

La figure 3a montre schématiquement l'antenne 14 munie d'un dispositif de symétrisation. L'antenne 14 comporte une boucle de courant formée de deux brins conducteurs 18 et 19 courbes et symétriques. Ces deux brins sont réunis entre eux, à leurs extrémités par deux capacités $C_1$ et $C_2$. Les capacités $C_1$ et $C_2$ sont calculées pour provoquer avec les brins 18 et 19 une grande surtension pour un signal à la fréquence de résonance. La symétrisation est obtenue ici en raccordant un circuit de réception 20 aux bornes de l'une des deux capacités.

Dans une réalisation particulière, figure 3 b, le montage est conforme à celui de la figure 3 a et la connexion d'un circuit de réception preferré est montrée plus en détail. L'antenne présente une symétrie par rapport à un plan XOZ où Z est colinéaire à $B_0$ et où X est perpendiculaire au plan de l'antenne. De cette symétrie il résulte une partition de la boucle en quatre demi-brins notés 21 à 24. Les demi-brins 22 et 23 d'une part et 21 et 24 d'autre part sont d'égale longueur et possèdent la même forme. Les demi-brins 22 et 23 sont raccordés ensemble à une de leurs extrémités, et à des capacités $C_1$ et $C_2$ respectivement à leurs autres extrémité. Les demi-brins 21 et 24 sont aussi reliés ensemble à une de leurs extremités et respectivement aux capacités $C_1$ et $C_2$ à leurs autres extremités. Les sections des conducteurs des demi-brins sont les mêmes. ILs peuvent par exemple être des conducteurs creux.

Dans l'invention le demi-brin 21 forme cependant avec un conducteur qui lui est parallèle, un tronçon T de ligne haute fréquence. Ce tronçon T est plus long qu'un demi-brin normal : le demi-brin 24 lui est relié éléctriquement à un certain endroit pour déterminer avec le demi-brin 21, et pour constituer avec lui de brin 18. La symétrisation est obtenue en raccordant le point chaud de la ligne à l'extrémité 40 du demi-brin 22 (connectée à la capacité $C_1$) d'une part, et à un circuit d'adaptation-amplification 25 d'autre part. D'une manière préférée les demi-brins 22,23 et 24 sont constitués à partir d' éléments de câbles coaxiaux dont les âmes, inutiles, sont laissées en l'air. Le tronçon T peut être constitué à partir d'un câble coaxial identique. Dans cet exemple le point chaud de la ligne haute fréquence est constitué par l'âme du tronçon T. Elle est reliée par une connexion 41 au demi-brin 22.

Le circuit 25 est placé à proximité immédiate de l'antenne (quelques centimètres). Il comporte essentiellement un transistor 26 a effet de champ (FET). Le transistor 26 est alimenté par une alimentation 27, découplée, et de type connu dont le potentiel (Vcc) est transporté par l'âme d'un câble coaxial de liaison 28. Le circuit 25 comporte en outre une résistance de polarisation 29 et une capacité de découplage 30 montées en émetteur commun. Le circuit 25, qui constitue un amplificateur à haute impédance d'entrée, effectue la transformation de l'impédance de l'antenne 14 pour l'adapter à celle de la ligne 28. En effet l'égalité des courants circulant dans les brins conducteurs 18 et 19 et dans les capacités $C_1$ et $C_2$ entraine une très forte impédance du circuit résonnant présentée à l'entrée de l'amplificateur 25. Alors que ce circuit débite dans une charge faible par l'intermédiaire de la ligne 28, par sa forte impédance d'entrée le circuit 25 réalise la transformation d'impédance. La ligne 28 sert aussi à transporter le signal reçu vers les moyens de traitement 15. Dans un exemple le tronçon T est fabriqué à partir d'un élément de câble coaxial d'impédance caractéristique 50 Ohms. A une fréquence de résonance de 20 MHz, la longueur d'onde du signal de résonance vaut environ 15 mètres. Le tronçon T, dont la longueur peut être de l'ordre de 0,50 mètre (bien inférieure au quart de la longueur d'onde) et qui est chargé par une impédance quasiment infinie (celle du circuit 25), se comporte comme une impédance capacitive de valeur $C_T$. Le circuit amplificateur-adaptateur 25 a par ailleurs un schéma équivalent alternatif composé d'une résistance $R_A$ en parallèle avec une capacité $C_A$. L'accord en fréquence de la boucle de courant par les capacités $C_1$ et $C_2$ en est modifié. Dans ces conditions on choisit $C_1$ tel que :
$$C_2 = C_1 + C_T + C_A.$$

L'extrémité 31 du tronçon T raccordée au circuit 25 est colinéaire à l'axe Z. Aussi aucun courant de mode commun ne peut plus circuler dans l'âme du tronçon T du fait de la symétrie électrique et mécanique du dispositif. Dans une réalisation particulière la boucle 14 est installée sur une feuille isolante en un matériau souple et résistant; le tronçon de ligne T peut y être réalisé sous forme de microbande. Ceci facilite la mise en place sur le corps. Le circuit 25 est placé directement en aval de l'antenne, sur la même feuille. Le câble 28 relie ce circuit, posé sur le corps dans le tunnel de l'appareil de RMN, au circuit 15.

**Revendications**

1 - Antenne de surface (14) de réception pour appareil d'imagerie par résonance magnétique nucléaire comportant des moyens (18-24) pour assurer sa symétrisation pour la réception du signal de résonance et un circuit (25) pour assurer la transformation de son impédance pour la transmission de ce signal de résonance caractérisée en ce que les moyens de symétrisation comportent une boucle selfique (18-19) accordée en fréquence par une capacité répartie comportant au moins une capacités ($C_1$-$C_2$) disposées symétriquement dans la boucle, et un circuit (25) de réception du signal induit dans la boucle, branché (41) aux bornes de l'une des capacités, ce circuit de réception comportant un tronçon (T) d'une ligne haute fréquence dont un conducteur de masse (21) participe à la boucle selfique et dont une âme, qui sert à conduire le signal reçu, est reliée d'une part au reste ($C_1$) de la boucle et d'autre part au circuit (25) de transformation d'impédance.

2 - Antenne selon la revendication 1 caractérisée en ce que la boucle présente une symétrie géométrique par rapport à un plan (XOZ), qui la coupe sensiblement perpendiculairement à son propre plan.

3 - Antenne selon la revendication 2 caractérisée en ce que l'extrémité (31) du tronçon (T) de ligne haute fréquence reliée au circuit de transformation d'impédance est contenue dans le plan de symétrie.

4 - Antenne selon l'une quelconque des revendications 1 à 3 caractérisée en ce que la section du conducteur qui forme le reste de la boucle est celle d'un câble coaxial identique à celui du tronçon (T) de ligne haute fréquence.

5 - Antenne selon l'une quelconque des revendications 1 à 4 caractérisée en ce que le circuit de transformation d'impédance est un circuit à haute impédance d'entrée.

6 - Antenne selon la revendication 5 caractérisée en ce que le circuit de transformation d'impédance est placé à proximité immédiate de l'antenne.

7 - Antenne selon la revendication 6 caractérisée en ce que le circuit de transformation d'impédance comporte un transistor (26) à effet de champ monté en émetteur commun (29-30).

8 - Antenne selon la revendication 7 caractérisée en ce que le transistor à effet de champ est alimenté par une tension de polarisation (Vcc) découplée (27) du signal amplifié et placée à distance (28).

9 - Antenne selon la revendication 3 caractérisé en ce que les capacités d'accord des deux parties symétriques de la boucle sont égales.

## Patentansprüche

1. Oberflächen-Empfangsantenne (14) für ein Gerät zur Bilderzeugung mittels magnetischer Kernresonanz, mit Mitteln (18–24) zur Sicherung ihrer Symmetrisation für den Empfang des Resonanzsignals und einem Schaltkreis (25) zur Sicherung der Umwandlung (25) ihrer Impedanz für die Übertragung dieses Resonanzsignals, dadurch gekennzeichnet, daß die Symmetrisationsmittel eine induktive Schleife (18–19) enthalten, die durch eine verteilte Kapazität frequenzabgestimmt ist, die mindestens eine symmetrisch in der Schleife angeordnete Kapazität ($C_1$-$C_2$) umfaßt, und einen Schaltkreis (25) für den Empfang des in der Schleife induzierten Signals, der an die Klemmen einer der Kapazitäten angeschlossen (41) ist, wobei dieser Empfangskreis einen Abschnitt (T) einer Hochfrequenzleitung umfaßt, von der ein Masseleiter (21) an der induktiven Schleife teilnimmt, und von der eine Seele, die zum Führen des empfangenen Signals dient, einerseits

mit dem Rest ($C_1$) der Schleife und andererseits mit den Schaltkreis (25) für die Impedanzwandlung verbunden ist.

2. Antenne nach Anspruch 1, dadurch gekennzeichnet, daß die Schleife eine geometrische Symmetrie gegenüber einer Ebene (XOZ) aufweist, die sie etwa senkrecht zu ihrer eigenen Ebene schneidet.

3. Antenne nach Anspruch 2, dadurch gekennzeichnet, daß das äußerste Ende (31) des Abschnitts (T) der mit dem Impedanzwandlungskreis verbundenen Hochfrequenzleitung in der Symmetrieebene enthalten ist.

4. Antenne nach einem der Ansprüche 1 bis 3, dadurch gekennzeichnet, daß der Querschnitt des den Rest der Schleife bildenden Leiters derjenige eines mit dem des Abschnitts (T) der Hochfrequenzleitung völlig übereinstimmenden Koaxialkabels ist.

5. Antenne nach einem der Ansprüche 1 bis 4, dadurch gekennzeichnet, daß der Impedanzwandlungskreis ein Schaltkreis mit hohem Eingangswiderstand ist.

6. Antenne nach Anspruch 5, dadurch gekennzeichnet, daß der Impedanzwandlungskreis in unmittelbarer Nähe der Antenne untergebracht ist.

7. Antenne nach Anspruch 6, dadurch gekennzeichnet, daß der Impedanzwandlungskreis einen Feldeffekttransistor (26) umfaßt, der auf einen gemeinsamen Sender (29–30) montiert ist.

8. Antenne nach Anspruch 7, dadurch gekennzeichnet, daß der Feldeffekttransistor mit einer vom verstärkten Signal entkoppelten (27) und weiter weg angelegten (28) Polarisationsspannung (Vcc) gespeist ist.

9. Antenne nach Anspruch 3, dadurch gekennzeichnet, daß die Abstimmungskapazitäten der beiden symmetrischen Teile der Schleife gleich sind.

## Claims

1. A surface receiving antenna (14) for an image producing apparatus using nuclear magnetic resonance, comprising means (18 through 24) in order to ensure symmetry for the reception of the resonance signal and a circuit (25) in order to ensure the transformation of its impedance for the transmission of this resonance signal, characterized in that the symmetry ensuring means comprising a self-inductance loop (18 and 19) tuned in frequency by a distributed capacitance comprising at least one capacitor ($C_1$ and $C_2$) placed symmetrically in the loop and a reception circuit (25) for the signal induced in the loop, connected (41) with the terminals of one of the capacitors, the said reception circuit comprising a limb (T) of a radio frequency line whose one ground conductor (21) participates in the self-inductance loop and of which a core, which serves to conduct the received signal, is connected at one end with the rest ($C_1$) of the loop and at the other end with the impedance transformation circuit (25).

2. The antenna as claimed in claim 1, characterized in that the loop is geometrically symmetrical in relation to a plane (XOZ) which intersects it substantially perpendicularly to its own plane.

3. The antenna as claimed in claim 2, characterized in that the end (31) of the limb (T) of the radio frequency line connected with the impedance transformation circuit is contained in the plane of symmetry.

4. The antenna as claimed in any one of the claims 1 through 3, characterized in that the section of the conductor which forms the rest of the loop is that of a coaxial cable identical to that of the limb (T) of the radio frequency line.

5. The antenna as claimed in any one of the preceding claims 1 through 4, characterized in that the impedance transformation circuit is a high input impedance circuit.

6. The antenna as claimed in claim 5 characterized in that the impedance transformation circuit is placed in the immediate proximity of the antenna. .

7. The antenna as claimed in claim 6 characterized in that the impedance transformation circuit comprises a field effect transistor (26) in a common emitter circuit (29 and 30).

8. The antenna as claimed in claim 7 characterized in that the field effect transistor is supplied with a polarizing voltage (Vcc) decoupled (27) from the amplified signal and is placed at a distance (28).

9. The antenna as claimed in claim 3 characterized in that the matching capacitors of the two symmetrical parts of the loop are equal.

# FIG_1-a

# FIG_1-b

# FIG_2

FIG_3-a

FIG_3-b